Europäisches Patentamt

European Patent Office

Office européen des brevets

(11) Numéro de publication: **0 143 706**
**A1**

## (12) DEMANDE DE BREVET EUROPEEN

(21) Numéro de dépôt: **84402363.0**

(22) Date de dépôt: **20.11.84**

(51) Int. Cl.⁴: **H 01 L 27/14**

(30) Priorité: **25.11.83 FR 8318845**

(43) Date de publication de la demande: **05.06.85**
**Bulletin 85/23**

(84) Etats contractants désignés: **DE GB NL SE**

(71) Demandeur: **THOMSON-CSF, 173, Boulevard Haussmann, F-75379 Paris Cedex 08 (FR)**

(72) Inventeur: **Munier, Bernard, THOMSON-CSF SCPI 173, bld Haussmann, F-75379 Paris Cedex 08 (FR)**

(74) Mandataire: **Mayeux, Michèle et al, THOMSON-CSF SCPI 173, Bld Haussmann, F-75379 Paris Cedex 08 (FR)**

(54) **Dispositif photosensible pour l'infra-rouge.**

(57) Chaque détecteur infrarouge est associé à des moyens (2) permettant l'injection dans un substrat semi-conducteur d'une quantité de charges fonction du rayonnement infrarouge reçu par le détecteur, et à des moyens (62) assurant le stockage de ces charges. Les moyens de stockage des détecteurs d'une même ligne sont reliés par des connexions (... 11 (j-l), 11 (j-l), 11 (j), 11 (j + 1) ...) à des moyens de lecture des charges, communs aux détecteurs d'une même ligne, et qui assurent, grâce à un registre à décalages qui adresse successivement les moyens de stockage des détecteurs d'une même colonne, la lecture des détecteurs, colonne après colonne. L'ensemble du dispositif peut être intégré dans un cryostat présentant une seule sortie à haut niveau.

# DISPOSITIF PHOTOSENSIBLE POUR L'INFRA-ROUGE

La présente invention concerne un dispositif photosensible pour l'infra-rouge.

Ce dispositif peut comporter une mosaïque bi-dimensionnelle de détecteurs, répartis selon M lignes et N colonnes, ou il peut comporter une barrette, c'est-à-dire une seule ligne, de N détecteurs.

On connait dans l'art antérieur différents types de dispositifs photosensibles pour l'infra-rouge.

On va brièvement rappeler ci-après le fonctionnement de trois de ces dispositifs.

Par l'article intitulé "Electronically scanned CMT detector array for the 8-14 $\mu$m band", paru dans la revue "Electronics Letters", du 1er avril 1982, volume 18, numéro 7, pages 285 à 287, on connait un dispositif dans lequel chaque détecteur est associé à un transistor MOS. Un registre à décalage permet par l'intermédiaire des transistors MOS d'adresser successivement chaque ligne de détecteurs. Les charges provenant des détecteurs de la ligne adressée sont stockées par une série d'amplificateurs opérationnels montés en intégrateurs, chaque amplificateur étant relié par l'intermédiaire des transistors MOS aux détecteurs d'une même colonne. Un multiplexeur permet de lire séquentiellement les intégrateurs, puis une autre ligne de détecteurs est adressée par le registre.

Il faut remarquer que dans ce type de dispositif l'intégration des charges est réalisée successivement pour chaque ligne de détecteurs par les mêmes amplificateurs montés en intégrateurs. La durée d'intégration des charges provenant de chaque détecteur est donc fortement limitée. Un autre inconvénient de ce type de dispositif est que les amplificateurs opérationnels ne peuvent pas être placés dans le cryostat renfermant les détecteurs et le reste du dispositif. Ce cryostat comporte donc de nombreuses sorties à faible niveau.

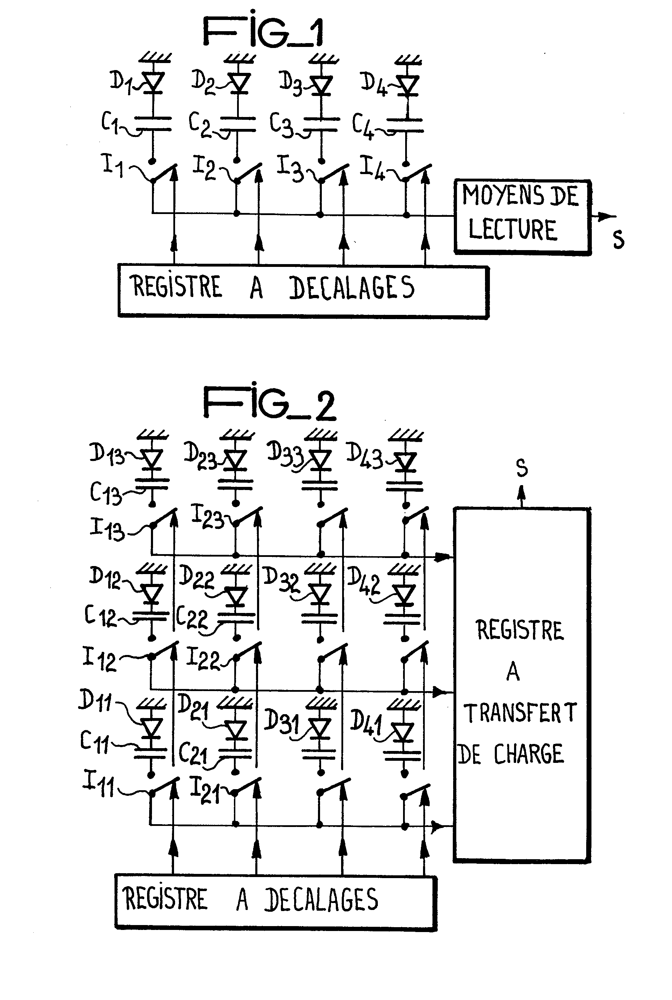

Par l'article intitulé "CCD readout of infrared hybrid focal-plane arrays", paru dans la revue "I.E.E.E. Transactions on Electron Devices", volume ED 27, numéro 1, janvier 1980, pages 175 à 188, on connait un autre type de dispositif. Dans ce dispositif -voir figure 2- de l'article cité - chaque détecteur est associé à une capacité de stockage des charges qui est reliée à l'une des entrées d'un registre à transfert de charge.

Dans ce type de dispositif, on adresse simultanément toutes les lignes de détecteurs pour que le contenu des capacités de stockage soit transféré dans les registres à décalages à entrées parallèles et sortie série. Les sorties de ces registres sont reliées aux entrées d'un autre registre à décalage à transfert de charge à sortie série qui fournit le signal de sortie du dispositif. Dans ce type de dispositif, la durée d'intégration des charges peut être importante et l'ensemble du dispositif peut être contenu dans un cryostat. L'inconvénient de ce type de dispositif est notamment qu'il y a perte de l'information à cause de l'inefficacité de transfert des registres à transfert de charge. Cette inefficacité est accrue par la très basse température -77 K par exemple-du cryostat et par le grand nombre de transferts à effectuer -400 transferts pour 100 détecteurs par exemple--. Un autre inconvénient de ce type de dispositif est son encombrement.

Pour chaque détecteur, il faut stocker les charges dans une capacité de stockage, pendant le temps d'intégration, puis dans un registre à décalages à transfert de charge, pendant le temps de lecture. Deux surfaces de stockage sont donc nécessaires pour chaque détecteur.

Enfin, on va terminer cette récapitulation de différents types de dispositifs photosensibles pour l'infra-rouge, par les dispositifs dans lesquels l'intégration des charges se fait dans les détecteurs-mode de fonctionnement dit "VIDICON"-. Ce type de fonctionnement donne des performances médiocres dans le cas des détecteurs infra-rouge, en particulier ceux qui sont sensibles dans la

0143706

bande 8 - 12 µm.

La présente invention concerne un nouveau type de dispositif photosensible pour l'infra-rouge qui comme celui décrit dans l'article d'I.E.E.E. cité comporte une capacité de stockage par détecteur. Dans certains de ses modes de réalisation, ce dispositif peut être placé dans un cryostat, ne présentant qu'une seule sortie à haut niveau. Par rapport au dispositif selon l'article d'I.E.E.E., le dispositif selon l'invention permet, pour un même encombrement, un temps d'intégration 3 à 5 fois plus important. En effet, dans le dispositif selon l'invention il est possible d'augmenter la contenance des capacités de stockage car l'encombrement du reste du dispositif est plus restreint.

En particulier, des moyens de stockage des charges sont associées à chaque détecteur mais les moyens de lecture sont communs aux détecteurs d'une même ligne.

Selon la revendication 1, la présente invention concerne un dispositif photosensible pour l'infra-rouge, comportant au moins une ligne de plusieurs détecteurs infra-rouge, intégrés sur un premier substrat semi-conducteur, placé dans un cryostat, chaque détecteur étant relié à des moyens permettant l'injection dans un second substrat semi-conducteur, placé dans le cryostat, d'une quantité de charges fonction du rayonnement infra-rouge reçu par chaque détecteur, ce dispositif comportant des moyens propres à chaque détecteur assurant le stockage des charges dans le second substrat et comportant des moyens de lecture des charges, caractérisé en ce que les moyens de stockage des détecteurs d'une même ligne sont reliés par une connexion aux moyens de lecture, communs à ces détecteurs, et qui assurent, grâce à un registre à décalage adressant successivement les moyens de stockage de chaque détecteur d'une même ligne, la lecture séquentielle des détecteurs d'une même ligne.

D'autres objets, caractéristiques et résultats de l'invention ressortiront de la description suivante, donnée à titre d'exemple non limitatif et illustrée par les figures annexées qui représentent :

- les figures 1 et 2, les schémas de deux modes de réalisation du dispositif selon l'invention ;

- les figures 3 et 4, des vues de dessus des moyens d'injection et de stockage et des moyens de lecture des charges, pour un mode de réalisation du dispositif selon l'invention, dans le cas d'une barrette de détecteurs ;

- les figures 5a, b, c et d, une vue en coupe selon les lignes AA' et BB' des figures 3 et 4, et des schémas expliquant le fonctionnement du dispositif ;

- les figures 6a, b, c, d et e, des signaux de commande et le signal de sortie du dispositif des figures 3, 4, 5 ;

- la figure 7, une vue de dessus d'un mode de réalisation d'un dispositif selon l'invention, dans le cas d'une mosaïque de détecteurs.

- les figures 8a, b,c et d, une vue en coupe selon la ligne CC' de la figure 7 et des schémas expliquant le fonctionnement du dispositif.

Sur les différentes figures, les même repères désignent les mêmes éléments, mais, pour des raisons de clarte, les cotes et proportions de divers éléments ne sont pas respectées.

La figure 1 représente le schéma d'un mode de réalisation d'un dispositif photosensible pour l'infra-rouge selon l'invention.

Il comporte une barrette de N photodiodes, avec sur la figure N égale 4, dont l'anode est reliée à la masse, et qui sont intégrées sur un premier substrat semi-conducteur placé dans un cryostat.

Chaque photodiode $D_1$, $D_2$, $D_3$ et $D_4$ est reliée par sa cathode à des moyens permettant l'injection dans un second substrat semi-conducteur, en silicium par exemple, qui est placé dans le cryostat, d'une quantité de charges qui dépend du rayonnement infra-rouge reçu par chaque détecteur. Ce dispositif comporte des moyens propres à chaque détecteur assurant le stockage des charges dans le second substrat semi-conducteur.

Sur la figure 1, on a représenté symboliquement les moyens d'injection et de stockage des charges par une capacité $C_1$, $C_2$, $C_3$, $C_4$ reliée à la cathode de chaque photodiode $D_1$, $D_2$, $D_3$, $D_4$.

Chacune des capacités est reliée par l'intermédiaire d'un interrupteur $I_1$, $I_2$, $I_3$, $I_4$ à des moyens de lecture communs à tous les détecteurs et qui fournissent le signal de sortie S du dispositif. Les interrupteurs $I_1$, $I_2$, $I_3$, $I_4$ sont commandés par les sorties d'un registre à décalage. On ne ferme qu'un seul interrupteur à la fois, par exemple $I_1$ est fermé, puis $I_2$, puis $I_3$... ce qui assure la lecture séquentielle des détecteurs $D_1$, $D_2$, $D_3$, $D_4$. Il suffit pour cela de transférer d'une sortie à l'autre du registre un signal assurant la fermeture des interrupteurs.

La figure 2 représente le schéma d'un mode de réalisation d'un dispositif selon l'invention. Le dispositif diffère de celui de la figure 1 car il s'agit d'une mosaïque bi-dimensionnelle, de M lignes et N colonnes de photodiodes, avec sur la figure 2, M = 3 et N = 4.

Chaque sortie du registre à décalages adresse simultanément les interrupteurs associés aux détecteurs d'une même colonne. Ainsi une sortie du registre adresse simultanément les interrupteurs $I_{11}$, $I_{12}$, $I_{13}$ associés aux détecteur $D_{11}$, $D_{12}$, $D_{13}$ la sortie suivante adresse les interrupteurs $I_{21}$, $I_{22}$, $I_{23}$ associés aux détecteurs $D_{21}$, $D_{22}$, $D_{23}$... et ainsi de suite.

Chaque détecteur est relié à des moyens d'injection et de stockage -symbolisés par une capacité- et à un interrupteur. Les interrupteurs associés aux détecteurs d'une même ligne sont reliés par une même connexion à une entrée d'un registre à décalages à transfert de charge à entrées parallèles et sortie S série. Le registre à décalages à sorties parallèles adresse successivement chaque colonne de détecteurs et les charges contenues dans les moyens de stockage sont transférées simultanément en parallèle dans le registre à transfert de charge, puis transférées en série jusqu'à la sortie S, de ce registre auquel est associé un dispositif de lecture des charges. Lorsque le transfert dans le registre à transfert de charge des charges, provenant d'une colonne de détecteurs est terminé, l'intégration des charges reprend pour cette colonne de détecteurs.

Selon les modes de réalisation des moyens de lecture reliés à chaque ligne de détecteurs, l'ensemble du dispositif selon l'invention est ou non contenu dans un même cryostat, comme on le verra dans la suite de la description.

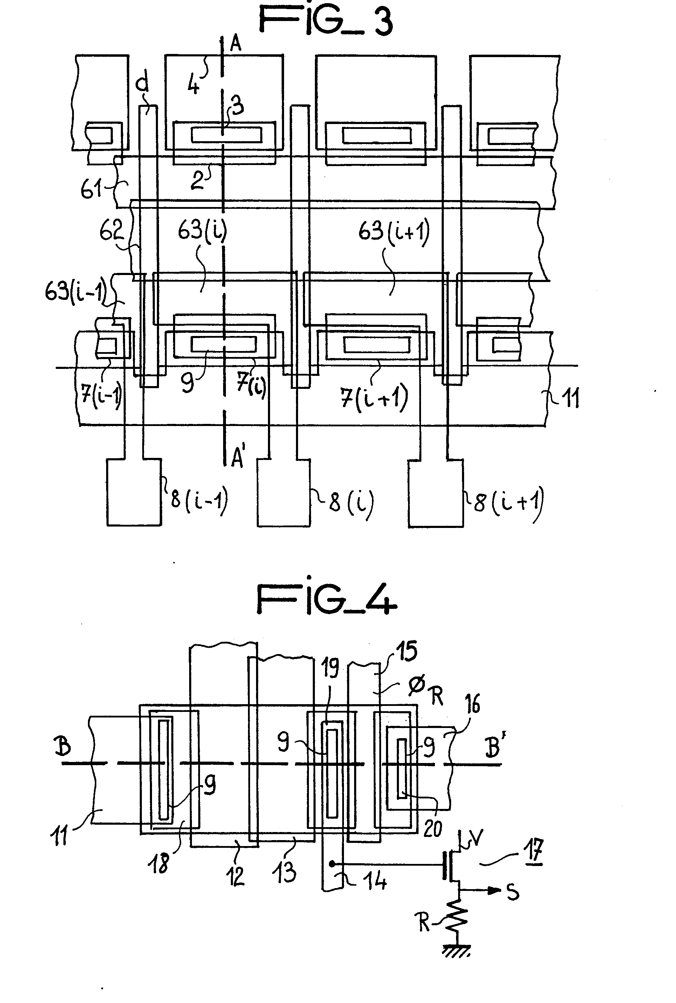

Les figures 3, 4 et 5 concernent un mode de réalisation d'un dispositif selon l'invention dans le cas d'une barrette de détecteurs. Les figures 3 et 4 sont des vues de dessus de certaines parties de ce dispositif.

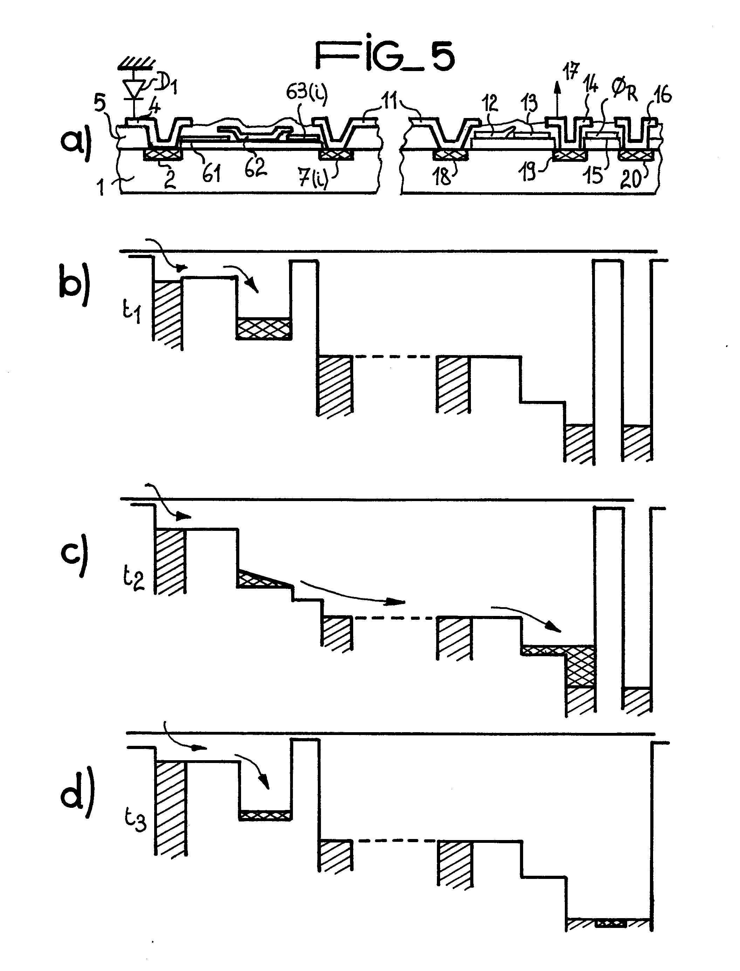

La figure 5a est une vue en coupe transversale de ce dispositif et les figures 5b, c et d représentent des schémas expliquant son fonctionnement.

Les détecteurs, tels que la photodiode $D_1$ sur la figure 5a sont reliés par un contact métallique 4 à une diode d'entrée 2 grâce à une ouverture 3 réalisée dans la couche d'isolant 5 qui recouvre le substrat semi-conducteur 1, en silicium de type P par exemple. Une première grille 61, déposée sur la couche d'isolant 5, contrôle le potentiel de surface du canal d'entrée. Les photodiodes sont donc maintenues à un potentiel constant par la grille $G_1$. Lorsque le potentiel de surface sous la diode 2 devient inférieur au potentiel imposé par la grille $G_1$, il y a transfert de charge de la diode 2 vers la grille $G_2$. Dans l'exemple représenté sur la figure 3, cette grille 61 est horizontale et contrôle le canal d'entrée associé à chaque détecteur de la barrette. Cette grille 61 est portée à un potentiel constant. Une deuxième grille 62 est utilisée pour stocker les charges provenant des détecteurs. Sur la figure 3, la grille 62 est également commune à tous les étages d'entrée associés aux détecteurs de la barrette.

On fixe les limites des canaux véhiculant les charges provenant de chaque détecteur en utilisant par example des diffusions d'isolement verticales appelées d sur la figure 3.

La deuxième grille 62 est suivie par une série de troisièmes grilles 63 (i -1), 63 (i), 63 (i + 1), isolées les uns des autres par les diffusions d'isolement d. Chacune de ces grilles est reliée par des plots de contacts 8 (i - 1), 8 (i), 8 (i + 1) aux sorties d'un registre à décalages à sorties parallèles tels que ceux des figures 1 et 2. Ce registre à décalages peut être constitué de transistors MOS. Il peut aussi s'agir d'un registre à décalages à transfert de charge. Ce registre peut sans difficulté être intégré dans le second substrat semi-conducteur.

Après les troisièmes grilles, on trouve une diode 7 (i - 1), 7 (i), 7 (i + 1) dans chaque canal.

Une connexion 11 est en contact direct avec ces diodes grâce à des fenêtres 9 réalisées dans la couche d'isolant 5 qui recouvre le substrat semi-conducteur. La connexion 11 est reliée aux moyens de lecture communs à toute la barrette et dont un mode de réalisation et représenté, vu de dessus, sur la figure 4. La connexion 11, en aluminium par exemple, est reliée à une diode 18 intégrée dans le second substrat semi-conducteur 1.

Dans le mode de réalisation de la figure 4, les moyens de lecture sont constitués de deux grilles 12 et 13 portées à des potentiels constants. Le niveau des charges sous les diodes... 7 (i - 1), 7 (i), 7 (i + 1)... et sous la diode 18 s'aligne sur le potentiel de surface existant sous la grille 12, comme on peut le voir sur les figures 5b, c et d. Les deux grilles 12 et 13 sont suivies par un transistor MOS intégré sur le second substrat semi-conducteur et constitué par une grille 15 et par deux diodes 19 et 20, en contact grâce à des fenêtres 9 réalisées dans la couche isolante 5 recouvrant le substrat 1 avec deux connexions 14 et 16. Un étage suiveur 17 est relié à la connexion 14. Sur la figure 4, cet étage est représenté schématiquement par un transistor MOS en série avec une résistance R également reliée à la masse. La sortie S du dispositif est prise à la connexion entre ce transistor MOS et la résistance. En fait, ce transistor MOS peut être intégré dans le second substrat semi-conducteur ainsi que la résistance R qui peut être réalisée par un autre transistor MOS.

La figure 5a est une vue en coupe transversale effectuée à travers le dispositif des figures 3 et 4 selon les lignes AA' et BB'. Les figures 5b, c, et d montrent l'évolution du potentiel de surface dans le substrat à différents instants $t_1$, $t_2$, $t_3$.

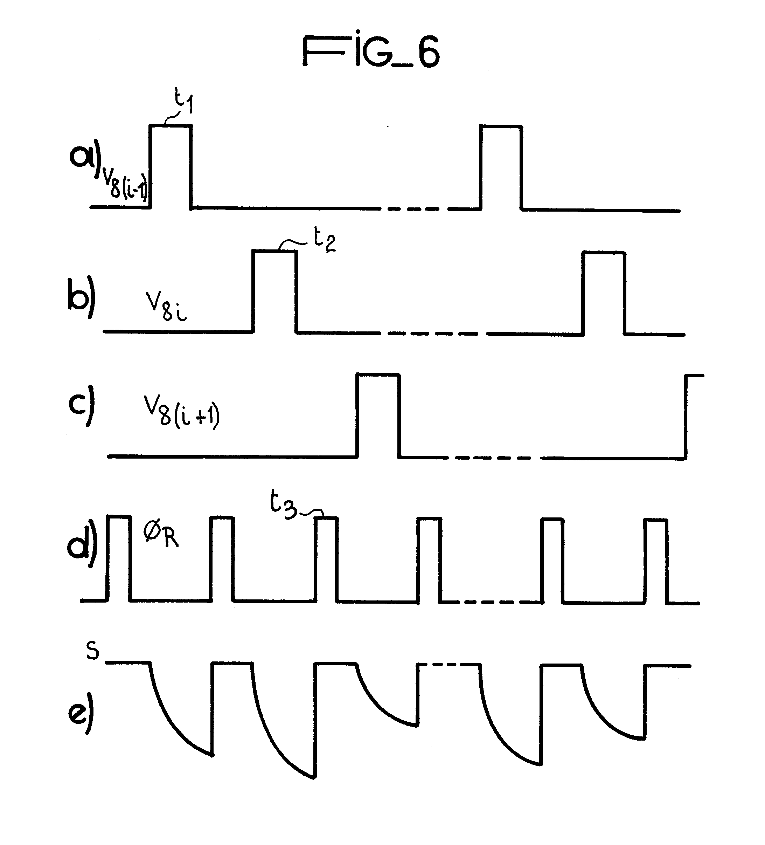

Sur les figures 6a, b et c, on à représenté les signaux $V_{8\ (i\ -\ 1)}$,

$V_{8\,(i)}$, $V_{8\,(i+1)}$ recueillis sur les sorties du registre à décalages reliées aux plots 8 (i - 1), 8 (i), 8 (i + 1). Ces signaux passent les uns après les autres au niveau haut. Sur la figure 6d, est représenté le signal de remise à zéro $\emptyset_R$ appliqué à la grille 15 du transistor qui termine l'étage de lecture. Sur la figure 6e, on a représenté le signal de sortie S du dispositif, obtenu en sortie de l'étage suiveur relié à la connexion 14.

A l'instant $t_1$, le signal $V_{8\,(i)}$ est au niveau bas -voir figure 5b- La grille 63 (i) empêche le passage des charges provenant du détecteur $D_{11}$ vers la connexion 11. Ces charges s'accumulent dans la capacité constituée par la grille 62.

Au temps $t_2$ -voir figure 5c- le signal $V_{8\,(i)}$ est au niveau haut et les charges dues au détecteur $D_1$ s'écoulent à travers la connexion 11 jusque sous la capacité constitué par la grille 13 et la diode 19. Il est possible de supprimer la grille 13. Le niveau des charges sous la diode 19 dont le potentiel est laissé flottant est lu par le suiveur de tension 17 relié à la connexion 14. Sur la figure 6e, on a représenté le signal obtenu sur la sortie S de l'étage suiveur de tension.

Les autres grilles ... 63 (i - 2), 63 (i - 1), 63 (i + 1), 63 (i + 2) ... sont au niveau bas et ne permettent pas le passage des charges vers la connexion 11.

Au temps $t_3$ - voir figure 5d - le signal $V_{8i}$ est à nouveau au niveau bas. Les charges dues au détecteur $D_1$ sont stockées sous la grille 62, alors que le passage au niveau haut du signal $\emptyset_R$ appliqué à la grille 15 assure la remise à niveau de la grille 13 et de la diode 19. Le potentiel de surface sous la diode 19 et la grille 15 s'aligne sur le potentiel de surface sous la diode 20.

Après que le détecteur $D_1$ ait été lu, le passage au niveau haut du signal $V_{8\,(i+1)}$ provoque la lecture du détecteur suivant.

Dans le mode de réalisation des figures 3, 4, 5, les moyens permettant l'injection des charges dans le second substrat semi-conducteur sont constitués par une diode à laquelle est reliée le photodétecteur. Il est bien entendu que ces moyens d'injection peuvent être constitués par une grille reliée au photodétecteur avec en amont à cette grille une diode qui fournit une quantité de charges contrôlée par la grille reliée au photo détecteur.

De même les détecteurs pour l'infra-rouge peuvent être par exemple des photodiodes ou par exemple des détecteurs du type grille -isolant- semi-conducteur.

Selon une variante du dispositif représenté sur les figures 3, 4 et 5, la grille 62 sous laquelle sont stockées les charges peut être constituée de grilles élémentaires 62 (i - 1), 62(i), 62 (i + 1)... adressées par le registre à décalage alors que les grilles 63 (i - 1), 63 (i), 63 (i + 1)... peuvent être remplacées par une grille 63 unique à un potentiel constant. Dans ce cas, le transfert des charges stockées sous l'une des grilles 62 vers la connexion 11, se fait par dessus la grille 63 en modifiant la polarisation de l'une des grilles de stockage 62.

En ce qui concerne les moyens de lecture, le mode de réalisation des figures 3, 4, 5 permet de placer la totalité du dispositif dans un cryostat présentant une seule sortie à haut niveau S. Les détecteurs et le reste du dispositif sont alors intégrés sur deux substrats semi-conducteurs différents et bien adaptés. Par exemple, pour les photo-détecteurs, de l'antimoniure d'indium, du tellurure d'étain et de plomb, du tellurure de cadmium et de mercure... Le reste du dispositif est intégré sur un substrat semi-conducteur en silicium du type P ou N, par exemple.

Dans le mode de réalisation des figures 3, 4 et 5, l'étage suiveur de tension 17 peut être remplacé par un amplificateur opérationnel monté en intégrateur et relié à la diode flottante 19 sous laquelle sont successivement envoyées les charges provenant de chaque détecteur de la barrette. Cet amplificateur est généralement externe au cryostat car sa température est trop élevée, et parce qu'il n'est pas possible de l'intégrer sur le second substrat semi-conducteur.

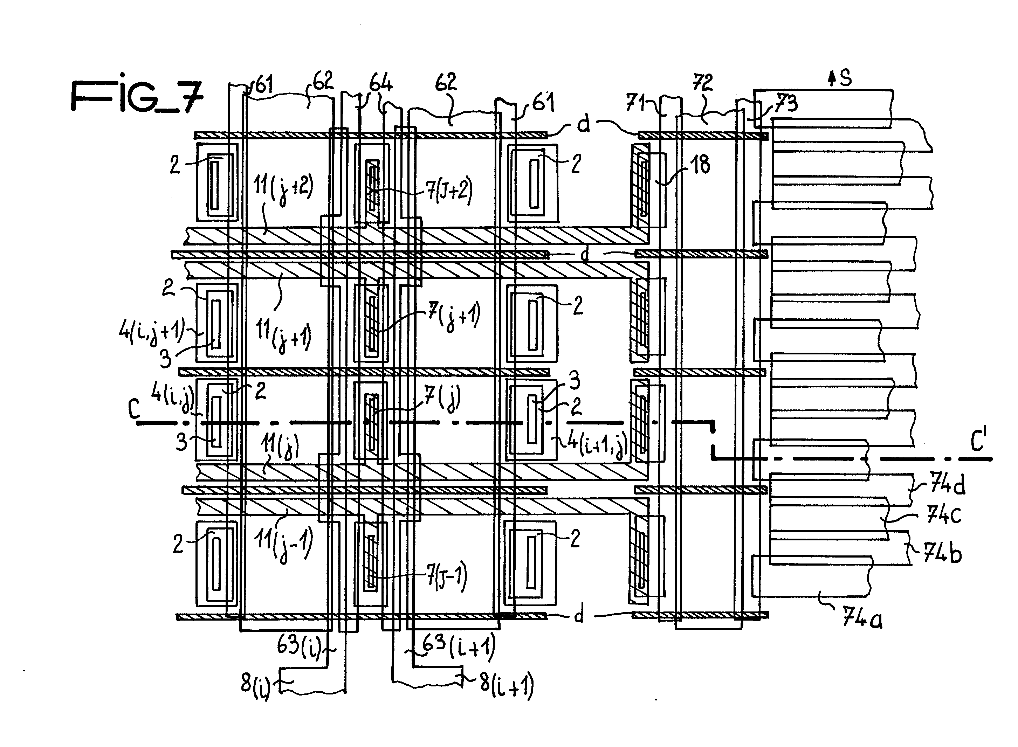

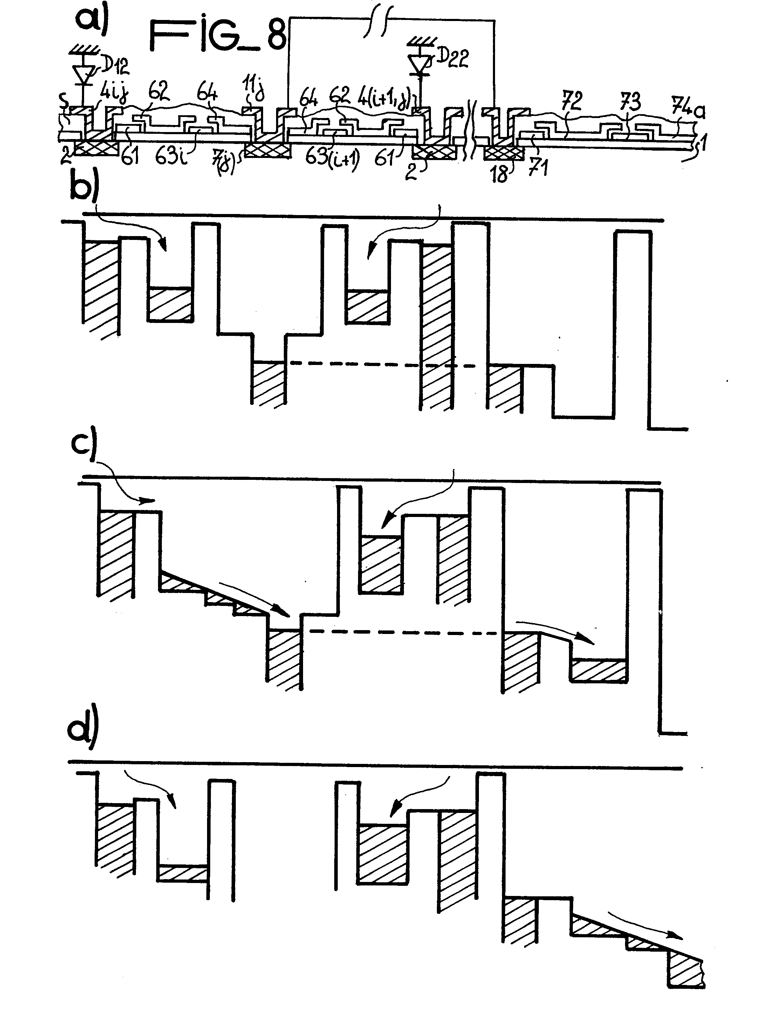

Les figures 7 et 8a, b, c, d sont relatives à un mode de réalisation du dispositif selon l'invention dans lequel les détecteurs sont répartis sous forme de mosaïque bi-dimensionnelle.

La figure 7 est une vue de dessus d'une partie de ce dispositif. La figure 8a est une vue en coupe transversale selon la ligne brisée CC' de la figure 7 et les figures 8b, c et d montrent l'évolution au cours du temps du potentiel de surface dans le substrat semi-conducteur.

Sur la figure 7, les détecteurs ne sont pas représentés. Le dispositif de la figure 7 est associé à une mosaïque de quatre lignes de deux détecteurs chacune. Chaque détecteur est relié par une connexion 4 (i, j), 4 (i + 1, j)... à une diode 2 intégrée dans le second substrat semi-conducteur 1 grâce à une fenêtre 3 réalisée dans la couche d'oxyde 5 qui recouvre le substrat. Les grilles 61 et 62 verticales qui sont communes à toutes les diodes 2 d'injection des charges d'une même colonne jouent le même rôle que les grilles 61 et 62 horizontales de la figure 3. Les grilles verticales 63 (i) et 63 (i + 1) jouent le même rôle que les grilles horizontales 63 (i - 1), 63 (i), 63 (i + 1)... de la figure 4. Des connexions 8 (i), 8 (i + 1)... relient chacune de ces grilles aux sorties d'un registre à décalage. Ainsi chaque colonne de détecteurs est successivement adressée. Les grilles verticales 64 portées à un potentiel constant jouent le rôle d'électrodes de blindage.

Entre les grilles 64, on trouve quatre diodes 7 (j - 1), 7 (j), 7 (j + 1), 7 (j + 2) sous lesquelles sont successivement déversées les charges provenant de la colonne de diodes 2 de droite ou de gauche. Cela permet de réduire l'encombrement du dispositif ou par exemple d'augmenter les capacités de stockage. Des connexions 11 (j - 1), 11 (j), 11 (j + 1), 11 (j + 2) relient les diodes 7 (j - 1), 7 (j)... associées aux détecteurs d'une même ligne à des moyens de lecture qui sont communs aux détecteurs d'une même ligne. On utilise donc ces moyens de lecture pour lire les uns après les autres les moyens de stockages des détecteurs d'une même ligne. Sur les figures 7 et 8, ces moyens de lecture comportent une diode 18 reliée par une fenêtre à travers l'isolant à l'une des connexions 11 (j - 1), 11 (j), 11 (j + 1)... Après les diodes 18, on trouve trois grilles verticales 71, 72, 73, communes à toutes les diodes 18. La grille 71 est à un potentiel constant et sert de blindage. Les grilles 72 et 73 jouent le même rôle que les grilles 12 et 13 de la figure 5a.

La grille 73 commande l'accès à un registre à décalage à transfert de charge vertical représenté sur la figure 7 par une succession de grilles 74a, b, c, d. Un dispositif de lecture des charges en courant ou en tension est associé à ce registre et fournit la sortie S du dispositif.

Des diffusions d'isolement horizontales d créent des canaux véhiculant les charges propres à chaque détecteur.

Les figures 8b,c et d montrent l'évolution du potentiel de surface dans le second substrat semi-conducteur à différents instants.

Sur la figure 8b, les charges dues aux détecteurs $D_{12}$ et $D_{22}$ sont stockées dans les capacités constituées par les grilles 62.

Sur la figure 8c, le registre à décalages adresse la grille 63 (i) et les charges dues au détecteur $D_{12}$ et aux autres détecteurs de la même colonne sont transférées vers les diodes ... 7 (j-1), 7 (j), 7 (j + 1)... et par l'intermédiaire des connexions 11 (j), 11 (j + 1)... sous les capacités existant sous la grille 72. Sur la figure 8d, il y a transfert en parallèle dans le registre à transfert de charge des charges dues aux détecteurs de la colonne i, alors que le stockage dans les capacités dues aux grilles 62 des charges dues aux détecteurs de cette colonne a repris. Ainsi, chaque colonne de détecteurs est lue séquentiellement par le registre à transfert de charge. Dans ce mode de réalisation, l'ensemble du dispositif peut être placé dans un cryostat ne comportant qu'une seule sortie à haut niveau. Dans le cas d'une mosaïque de détecteurs, il est possible d'utiliser les moyens de lecture décrits pour les barrettes, par exemple étage suiveur de tension ou amplificateurs opérationnels montés en intégrateur, il faut alors multiplexer les sorties de tous ces suiveurs ou amplificateurs.

Dans les divers modes de réalisation de l'invention qui ont été décrits, il est possible d'utiliser des grilles horizontales au lieu de grilles verticales et vice versa.

# REVENDICATIONS

1. Dispositif photosensible pour l'infra-rouge, comportant au moins une ligne de plusieurs détecteurs infra-rouge ($D_1$, $D_2$, $D_3$, $D_4$), intégrés sur un premier substrat semi-conducteur, placé dans un cryostat, chaque détecteur étant relié à des moyens permettant l'injection dans un second substrat semi-conducteur, placé dans le cryostat, d'une quantité de charge fonction du rayonnement infra-rouge reçu par chaque détecteur, ce dispositif comportant des moyens propres à chaque détecteur assurant le stockage des charges dans le second substrat et comportant des moyens de lecture des charges, caractérisé en ce que les moyens d'injection sont suivis par une première grille (61) portée à un potentiel constant, elle-même suivie par une deuxième grille (62) sous laquelle sont stockées les charges provenant d'un détecteur et par une troisième grille (63i), cette troisième grille étant reliée à une sortie d'un registre à décalages à sorties parallèles, ce registre adressant successivement la troisième grille associée à chaque détecteur d'une même ligne, cette troisième grille commandant l'accès à une diode (7i) reliée par une connexion à une autre diode (18) faisant partie des moyens de lecture qui sont communs aux détecteurs d'une même ligne et qui assurent la lecture séquentielle des détecteurs d'une même ligne.

2. Dispositif selon la revendication 1, caractérisé en ce que les moyens de lecture sont constitués par un étage suiveur (17) relié à une diode flottante (19) sur laquelle sont successivement envoyées les charges provenant de chaque détecteur d'une même ligne, ces moyens de lecture étant intégrés sur le second substrat semi-conducteur (1).

3. Dispositif selon la revendication 1, caractérisé en ce que les moyens de lecture comportent un amplificateur opérationnel monté en intégrateur externe au cryostat, relié à une diodes flottante (19), intégrée dans le second substrat (1) sur laquelle sont successivement envoyées les charges provenant de chaque détecteur d'une même ligne.

0143706

4. Dispositif selon la revendication 1, caractérisé en ce qu'il comporte plusieurs lignes de détecteurs et en ce que les moyens de lecture, intégrés dans le second substrat semi-conducteur, sont constitués par un registre à décalages à transfert de charge à entrées parallèles et à sortie série, recevant simultanément sur ses entrées les charges provenant des détecteurs des différentes lignes et d'une même colonne, ce registre étant relié à un dispositif de lecture des charges.

5. Dispositif selon l'une des revendications 1 à 4, caractérisé en ce que les détecteurs $(D_1, D_2, D_3)$ sont des photodiodes.

6. Dispositif selon la revendication 5, caractérisé en ce que l'anode de ces photodiodes $(D_1, D_2, D_3)$ est reliée à la masse et leur cathode est reliée à une diode (2) ou à une grille intégrée dans le second substrat semi-conducteur (1).

7. Dispositif selon l'une des revendications 1 à 6, caractérisé en ce que ce dispositif comporte plusieurs lignes de détecteurs et les diodes (7 (j - 1), 7 (j), 7 (j + 1) terminant les moyens de stockage sont communes à deux moyens de stockage adjacents.

8. Dispositif selon l'une des revendications 1 à 7, caractérisé en ce que le second substrat semi-conducteur (1) est en silicium.

9. Dispositif selon l'une des revendications 1 à 9, caractérisé en ce qu'il comporte plusieurs lignes et plusieurs colonnes de détecteurs et en ce que chaque sortie du registre à décalages à sorties parallèles adresse simultanément la troisième grille associée aux détecteurs d'une même colonne.

FIG_1

FIG_2

0143706

1/6

FIG_3

FIG_4

0143706

FIG_5

FIG_6

FIG_7

0143706

FIG_8

Office européen
des brevets

RAPPORT DE RECHERCHE EUROPEENNE

0143706
Numéro de la demande

EP  84 40 2363

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 038 725  (THOMSON-CSF) <br> * Figures 1,2; page 6, ligne 3 - page 11, ligne 17 * | 1 | H 01 L   27/14 |
| A | | 2,4,8, 9 | |
| | --- | | |
| Y,D | IEEE TRANSACTIONS ON ELECTRON DEVICES, vol. ED-27, no. 1, janvier 1980, pages 175-188, IEEE, New York, US; P. FELIX et al.: "CCD readout of infrared hybrid focal-plane arrays" * Figures 1,2 * | 1 | |
| | --- | | |
| A | Idem | 5-7 | |
| | --- | | **DOMAINES TECHNIQUES RECHERCHES (Int. Cl.4)** |
| A,D | ELECTRONICS LETTERS, vol. 18, no. 7, avril 1982, pages 285-287, Londres, GB; R.A. BALLINGALL et al.: "Electronically scanned CMT detector array for the 8-14 mum band" * Figure 1 * | 3 | H 01 L |
| | ----- | | |

| Le présent rapport de recherche a été établi pour toutes les revendications | | |
|---|---|---|
| Lieu de la recherche <br> LA HAYE | Date d'achèvement de la recherche <br> 05-03-1985 | Examinateur <br> CARDON A. |

OEB Form 1503 03.82

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant